# EUROPEAN PATENT SPECIFICATION

(11) **EP 1 693 889 B1**
(45) Date of publication and mention of the grant of the patent: **24.05.2017**
(21) Application number: 06447022.2
(22) Date of filing: 16.02.2006
(51) Int. Cl.: H01L 21/02, H01L 29/51, H01L 21/318, H01L 21/316, H01L 21/314, C23C 16/02, C23C 16/34

(54) **Method to enhance the initiation of film growth**
Verfahren zur Erhöhung der Initierung vom Wachstum einer Schicht
Procédé pour l'amélioration de l'initiation de la croissance d'une couche

(30) Priority: 16.02.2005 EP 05447030
(43) Date of publication of application: 23.08.2006
(73) Proprietor: IMEC, 3001 Leuven (BE); Renesas Electronics Corporation, Tokyo 135-0061 (JP)
(72) Inventor: Maes, Jan Willem, 2610 Wilrijk (BE); Delabie, Annelies, 3360 Bierbeek (BE); Shimamoto, Yasuhiro, Saitama 359-1111 (JP); Martin Hoyas, Ana, 3001 Leuven (BE)
(74) Representative: Pronovem

(56) References cited:
- US-A1- 2002 137 274
- US-A1- 2003 082 296
- US-A1- 2003 129 826
- US-A1- 2003 199 137
- US-A1- 2004 067 660
- US-A1- 2004 203 254
- US-B1- 6 506 668
- US-B1- 6 642 573
- KOH W ET AL: "MEETING THE CU DIFFUSION BARRIER CHALLENGE USING ALD TUNGSTEN NITRIDE CARBIDE" SOLID STATE TECHNOLOGY, PENNWELL CORPORATION, TULSA, OK, US, vol. 48, no. 6, 1 June 2005 (2005-06-01), pages 54-56,58, XP001233321 ISSN: 0038-111X
- TRAVALY Y. ET AL: "CHARACTERIZATION OF ATOMIC LAYER DEPOSITED NANOSCALE STRUCTURE ON DENSE DIELECTRIC SUBSTRATES BY X-RAY REFLECTIVITY" MICROELECTRONICS ENGINEERING, vol. 82, 18 August 2005 (2005-08-18), pages 639-644, XP002532984

## Description

### Field of the invention

The present invention as claimed in claim 1 relates generally to integrated circuit (IC) fabrication processes.

The present specification relates more particularly to the treatment of surfaces, such as silicon dioxide or silicon oxynitride layers, for the subsequent deposition of a metal, metal oxide, metal nitride or metal carbide layer. Any reference to "invention" and "embodiment" is to be regarded as an example of implementation of the teachings herein unless said "invention" or "embodiment" is specifically claimed.

### Background

Integrated circuit design is constantly being scaled down in pursuit of faster circuit operation and lower power consumption.

As semiconductor devices become smaller there is a need for higher dielectric constant (high-k) gate material.

Many high dielectric constant dielectric materials (high-k dielectric) have been investigated as possible replacements for silicon dioxide, which is the material of choice for the gate electrode. But one of the remaining problems is the deposition of said high-k materials on substrate surfaces for obtaining layer thickness compatible with the properties and applications sought.

WO02/43115 describes a method for treating substrate surfaces in preparation for subsequent nucleation-sensitive depositions and adsorption-driven deposition by means of non-depositing plasma products.

US 6,620,720 describes a method for reducing the thermal budget in a semiconductor manufacturing process wherein the remote thermal nitridation step is replaced by a remote plasma nitridation step.

US6642573 discloses deposition of dielectric material on silicon nitride which functions as a charge storage layer.

None of these methods allows the formation of a smooth, uniform and closed film (or layer) upon chemically stable substrate surfaces.

Indeed, up to the present invention, deposition of a high-k metal oxide on a chemically stable surface started slowly and through the local nucleation of three dimensional (higher than one monolayer) islands distributed all over the surface. Films closure took place only once the islands were big enough to grow together. Consequently, a certain minimum thickness of material had to be deposited before obtaining a closed film to be used for semiconductor applications (e.g. about 10 nm or more).

### Summary of the invention

Although a method of the invention is particularly suited for the deposition of high-k dielectric films, similar problems are encountered in the deposition of a metal, metal nitride, metal oxynitride or metal carbide film onto a chemically stable surface, for which a method of the invention can also beneficially be used.

The present invention provides a method for enhancing the growth of a metal, metal oxide, metal nitride, metal oxynitride, and/or metal carbide layer comprising the step of depositing said metal, metal oxide, metal nitride, metal oxynitride and/or metal carbide layer upon a SiₓN_{y} layer, wherein x and y are real numbers.

The present invention is based on the surprising discovery that the growth inhibition of a metal, metal oxide, metal nitride, metal oxynitride or metal carbide film is strongly reduced or even completely eliminated when said film is grown upon a Si₃N₄-like layer.

In a method according to the invention, said Si₃N₄-like layer has preferably a thickness comprised between (about) 0,25 nm and (about) 5 nm, more preferably between (about) 0,25 nm and (about) 4 nm, or even more preferably between (about) 1 nm and (about) 3 nm.

A method according to the invention allows enhancing the deposition of metal, metal oxide, metal nitride, metal oxynitride and/or metal carbide film(s) (or layers) upon said SiₓN_{y} layer, obtaining high quality ultra thin films, in particular films with a thickness of less than 8 nm, preferably of less than (about) 5 nm, less than (about) 4 nm, or less than (about) 3 nm, and more preferably of less than (about) 2 nm. Preferably, the thickness of said films is comprised between (about) 0,5 nm and (about) 8 nm, more preferably between (about) 0,5 nm and (about) 5 nm, and even more preferably between (about) 0,5 nm and (about) 2 nm.

A method of the invention for enhancing the growth of a metal, metal oxide, metal nitride, metal oxynitride and/or metal carbide layer comprises the step of depositing said metal, metal oxide, metal nitride, metal oxynitride and/or metal carbide layer upon a SiₓN_{y} layer, wherein x and y are real numbers.

Said metal, metal oxide, metal nitride, metal oxynitride and/or metal carbide can be deposited by a Physical Vapor Deposition (PVD) process (such as sputtering), by a Chemical Vapor Deposition (CVD) process, a Metal Organic CVD (MOCVD) process or an Atomic Layer Deposition (ALD) process.

In a method of the invention, said high-k metal oxide can be selected from the group consisting of titanium oxide, tantalum oxide, aluminium oxide, zirconium oxide, lanthanum oxide, hafnium oxide, hafnium scandium oxide, hafnium silicon oxide, and any combination of two, three, four, five or six thereof.

Said metal can be selected from the group consisting of tantalum, ruthenium, titanium, tungsten, aluminium, cupper, Cobalt, nickel, molybdenum, and any combination of two, three, four, five, six or more thereof.

Said metal nitride can be selected from the group consisting of tantalum nitride, titanium nitride, tungsten nitride, niobium nitride, molybdenum nitride, hafnium nitride, and any combination of two, three, four, five or six thereof.

In a method of the invention, said metal oxynitride can be selected from the group consisting of titanium oxynitride, tantalum oxynitride, aluminium oxynitride, zirconium oxynitride, lanthanum oxynitride, hafnium oxynitride, hafnium scandium oxynitride, hafnium silicon oxynitride, and any combination of two, three, four, five or six thereof.

Said metal carbide can be selected from the group consisting of tantalum carbide, titanium carbide, tungsten carbide, niobium carbide, molybdenum carbide, hafnium carbide, and any combination of two, three, four, five or six thereof. Further, any combination of a metal nitride and a metal carbide can be selected such a tungsten nitride carbide.

In a preferred method of the invention, said SiₓN_{y} layer is deposited upon a metal growth inhibiting surface, such as thermal oxide layers, in particular thermal SiO₂ layer or thermal SiON layer, before the step of depositing said metal, metal oxide, metal nitride, metal oxynitride and/or metal carbide layer.

Said SiₓN_{y} layer can be deposited by means of a Chemical Vapor Deposition process, using precursors comprising at least one silane and ammonia (NH₃), or by means of RACVD, RPECVD or PECVD process, using precursors comprising at least one silane and nitrogen radicals and optionally ammonia (NH₃).

Said at least one silane can be selected from the group consisting of monosilane, disilane, trisilane, monochlorosilane, dichlorosilane, trichlorosilane, and tetrachlorosilane.

The present invention also relates to the use of a Si₃N₄-like layer (or SiₓN_{y} layer) as a support for growing a metal, metal oxide, metal nitride, metal oxynitride and/or metal carbide layer. More particularly, said Si₃N₄-like layer is used for treating the layer underneath, for enhancing the growth of said metal, metal oxide, metal nitride, metal oxynitride and/or metal carbide layer.

In a preferred method or use according to the invention, a combination of metal nitride and metal carbide, more particularly tungsten nitride carbide (WNC), can be used.

In a preferred method or use according to the invention, said metal oxide is HfO₂.

Another object of the present invention relates to a high-k gate obtainable by a method of the invention.

### Brief description of the drawings

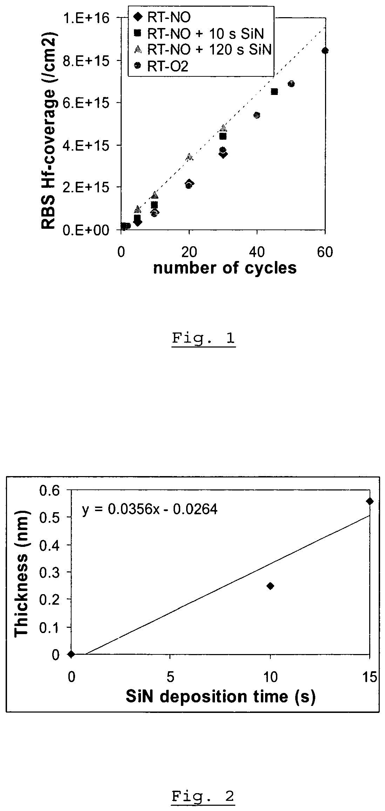

Figure 1 represents the growth curves of HfO₂ upon different substrate surfaces:
   - a thermal SiON layer grown in NO atmosphere at 1000°C (NO-RTO (Rapid Thermal Oxidation using Nitric Oxide (NO) as the oxidizing gas)),
   - a thermal SiO₂ layer grown in O₂ atmosphere at 750°C (O₂-RTO),
   - a Si₃N₄ layer deposited at 600°C by 10 seconds of a Radical Assisted Chemical Vapor Deposition (RACVD) process using SiH₄ and Nitrogen radicals, and
   - a Si₃N₄ layer deposited at 600°C by 120 seconds of a RACVD process using SiH₄ and Nitrogen radicals.
Figure 2 represents the XPS (X-Ray Photoelectron Spectroscopy) growth curve for Si₃N₄ upon a NO-RTO substrate.
Figure 3 represents the ellipsometer thickness of different substrate surfaces after their treatment by a RACVD process, a thermal CVD process using different precursors, or thermal or plasma assisted treatments in ammonia, nitrogen or hydrogen.
Figure 4 represents the growth curves of HfO₂ upon a NO-RTO SiON layer with or without different treatments of said SiON layer.
Figure 5 represents tungsten (W) yield for tungsten nitride carbide (WNC) layers grown on different surfaces as a function of number of ALD cycles measured by X-Ray Fluorescence (XRF).

### Detailed description of the invention

The present invention provides a method for enhancing the growth of a metal, metal oxide, metal nitride, metal oxynitride and/or metal carbide layer comprising the step of depositing said metal, metal oxide, metal nitride, metal oxynitride and/or metal carbide layer upon a SiₓN_{y}, wherein x and y are real numbers.

More preferably, the ratio x/y is comprised between about 0,75 and about 30, each value of this range being encompassed in the scope of the present invention.

The present invention also provides a method for treating a (substrate) surface in preparation of a subsequent deposition of a metal, metal oxide, metal nitride, metal oxynitride, and/or metal carbide layer comprising the step of depositing a SiₓN_{y} layer, wherein x and y are real numbers, wherein x is equal to (about) 3 or is higher than (about) 3, wherein y is higher than 0 and equal to or less than (about) 4, and wherein x and y may be equal or different, upon said (substrate) surface.

Said metal, metal oxide, metal nitride, metal oxynitride and/or metal carbide layer is/are deposited directly upon said SiₓN_{y} layer.

In the context of the present invention, the surface(s) to be treated is/are any surface(s) used in semiconductor processing on which the metal growth is inhibited (hindered/impeded). Said surface(s) can be referred to herein as "chemically stable surface(s)", as "(metal growth) inhibiting surface(s)", or as "difficult surface(s)".

Said surface(s) can be any (substantially) stoichiometric material(s), having a very low impurity content, on which inhibited film growth is usually observed. For example, thermal SiO₂ and thermal SiON are such surfaces.

Any metal(s) used in semiconductor processing, in particular for fabricating metal gates or for barrier layers, can be used in a method of the invention.

Said metal(s) can be deposited by a PVD (Physical Vapor Deposition) process such as sputtering, by an ALD (Atomic Layer Deposition) process, by a CVD (Chemical Vapor Deposition) process, by a MOCVD (Metal-Organic Chemical Vapor Deposition) process or by any other suitable processes.

For example, tantalum (Ta), ruthenium (Ru), titanium (Ti), tungsten (W), aluminium (Al), cupper (Cu), Cobalt (Co), nickel (Ni), molybdenum (Mo), or any combination of two, three, four, five, six or more thereof, can be used in a method of the invention.

The speed of a semiconductor device is directly proportional to the response of a gate dielectric in a field effect transistor (FET) after a voltage is applied. The response of a gate dielectric is directly proportional to its dielectric constant k and inversely proportional to its thickness. Thus, the need for a thin (even ultra-thin) and high k dielectric, depending on the applications, can be highly desirable for a gate dielectric.

In the context of the invention, a high k material is a material that has a dielectric constant higher than the dielectric constant of silicon dioxide (i.e. higher than about 3,9).

Any metal oxide(s) used in semiconductor processing, in particular for fabricating high-k dielectric metal oxide(s) gates, can be used in a method of the invention.

Said metal oxide (s) can be deposited by a PVD process such as sputtering, by an ALD process, by a CVD process, by a MOCVD process or by any other suitable processes.

For example, metal oxides (with high dielectric constant) that can be used are titanium oxide (TiO₂), tantalum pentoxide (Ta₂O₅), aluminium oxide (Al₂O₃), zirconium oxide (ZrO₂), lanthanum oxide (La₂O₃), hafnium oxide (HfO₂), or various combinations (in the form of multi-layers or multi-components) of two, three, four or more thereof. Further examples are ternary oxides such as metal silicon oxides, e.g. hafnium scandium oxide, in particular hafnium silicon oxide, barium strontium titanate (BST), lead zirconium titanate (PZT) and/or zirconium silicate.

Depending on the thickness of the metal oxide layer to reach, different processes such as PVD, ALD, CVD or MOCVD process can be carried out for depositing said metal oxides upon a SiₓN_{y} layer.

In a preferred method of the invention, the metal oxide material is deposited by an Atomic Layer Deposition (ALD) process.

Any metal nitride(s) used in semiconductor processing, in particular for fabricating metal gates, can be used in a method of the invention.

Said metal nitride(s) can be deposited by a PVD process such as sputtering, by an ALD process, by a CVD process, by a MOCVD process or by any other suitable processes.

For example, tantalum nitride (TaN), titanium nitride (TiN), tungsten nitride (WN), niobium nitride (NbN), molybdenum nitride (MoN), or any combination of two, three, four, or more thereof, can be used in a method of the invention.

Any metal carbide(s) used in semiconductor processing, in particular for fabricating metal gates, can be used in a method of the invention.

Said metal carbide (s) can be selected from the group consisting of tantalum carbide, titanium carbide, tungsten carbide, niobium carbide, molybdenum carbide, and hafnium carbide. Further, any combination consisting of a metal nitride and a metal carbide can be used such as tungsten nitride carbide.

Said metal carbides(s) can be deposited by a PVD process such as sputtering, by an ALD process, by a CVD process, by a MOCVD process or by any other suitable processes.

A method of the present invention may comprise the step of depositing said SiₓN_{y} layer upon a surface, in particular upon a metal growth inhibiting surface, such as a silicon oxide layer or a silicon oxynitride layer, before the step of depositing said metal, metal oxide, metal nitride, metal oxynitride, and/or metal carbide layer.

Said SiₓN_{y} layer can be deposited by any suitable process, preferably by a (thermal) Chemical Vapor Deposition (CVD), by a Radical Assisted Chemical Vapor Deposition (RACVD) process or by a (Remote) Plasma Enhanced Chemical Vapor Deposition (RPECVD or PECVD) process.

A (thermal) CVD process for depositing a SiₓN_{y} layer preferably makes use of precursors comprising at least one silane and ammonia (NH₃).

A RACVD, RPECVD or PECVD process for depositing a SiₓN_{y} layer preferably makes use of precursors comprising at least one silane and nitrogen radicals (N*), and optionally ammonia (NH₃).

In a method of the invention, said silane(s) can be selected from the group consisting of monosilane (SiH₄), disilane (Si₂H₆), trisilane (Si₃H₈), monochlorosilane, dichlorosilane (DCS), trichlorosilane (TCS) and tetrachlorosilane (SiCl₄, also referred to as silicon chloride).

In a preferred method according to the invention a hafnium oxide layer is deposited upon a Si₃N₄-like layer.

Up to the present invention, in gate stack applications, HfO₂ deposited on chemical oxides was found to have clearly better leakage current and thickness scaling properties than HfO₂ deposited on thermal oxide.

In parallel, the integration of HfO₂ with polysilicon electrodes in the gate stack was found to be problematic when a thermal oxide under-layer was used.

This was correlated with the fact that HfO₂ could grow well on chemical oxide and showed a clear growth inhibition on thermal oxide.

However thermally grown under-layers for HfO₂ are preferred in gate stack applications because of their better electrical properties, resulting in better carrier mobility in semiconductor devices.

A preferred method according to the present invention allows the manufacture of a high quality HfO₂ film on such thermal oxide under-layers. Said thermal oxide under-layers are thus treated before depositing said HfO₂ layer, the treatment comprising or consisting of the step of depositing a SiₓN_{y} layer.

A preferred method of the invention comprises thus the step of depositing a SiₓN_{y} layer upon a metal growth inhibiting surface, contiguously followed by the step of depositing a HfO₂ layer upon said SiₓN_{y} layer.

The minimal thickness of said SiₓN_{y} layer is about 0.25 nm, corresponding with a coverage of the metal growth inhibiting surface with about one molecular layer of SiₓN_{y}.

In a preferred method of the invention, the hafnium oxide layer is deposited by ALD process, which is commonly used for depositing films in the nanometer(s) thickness range.

The deposition is preferably performed at a temperature comprised between (about) 200°C and (about) 500°C, preferably between (about) 250°C and (about) 400°, more preferably at (about) 300°C, with precursors comprising or consisting of HfCl₄ and H₂O.

The pressure in the reactor can be comprised between (about) 0,1 and (about) 10 torrs (i.e. between (about) 0,0001333224 bar and (about) 0,01333224 bar), and is preferably (about) 1 Torr (i.e. (about) 0,001333224 bar).

As shown in figure 1, the HfO₂ growth enhancement depends on the Si₃N₄-like deposition time, in other words, depends on the thickness of the Si₃N₄-like layer.

For example, a Si₃N₄-like layer having a thickness of about 4 nm results in optimal HfO₂ growth properties. Nevertheless, a Si₃N₄-like layer thickness of about 0.25 nm is already sufficient for generating a significant enhancement of the HfO₂ layer growth.

In the meantime, for successful application of the surface treatment in a gate stack, it is important that the Si₃N₄-like layer deposited on the difficult surface does not result in an unacceptable increase of the electrical thickness (also referred to as Equivalent Oxide Thickness (EOT)) of the gate stack.

XPS analysis (figure 2) showed that the amount of material deposited after 10 seconds corresponds to a deposited Si₃N₄-like film thickness of about 0,25 nm. Such a thickness result in an increase in the EOT (Equivalent Oxide Thickness) of only about 0,12 nm. Thus a significant growth improvement can be achieved with a minor increase in the electrical thickness. Slightly longer treatments of about 15 seconds or about 20 seconds should result respectively in a Si₃N₄-like film thickness of about 0,5 nm and about 0,7 nm, increasing the electrical thickness (EOT) within acceptable limits to reach about 0,18 nm to about 0,24 nm.

For similar reasons, the HfO₂ layer thickness is preferably less than 8 nm, preferably less than (about) 7nm, more preferably less than (about) 5 nm, (about) 4 nm or (about) 3 nm, and even more preferably less than (about) 2 nm.

The Si₃N₄-like layer is deposited upon a (thermal) silicon oxynitride layer, but can also be deposited upon a (thermal) silicon oxide layer.

Different methods can be used for depositing said Si₃N₄-like layer.

For depositing said Si₃N₄-like layer a RACVD process can be performed, using precursors comprising or consisting of at least one silane, preferably SiH₄, with nitrogen radicals and optionally NH₃.

Said nitrogen radicals are preferably generated in a Radical Generator which is located adjacent to the reaction chamber. A suitable radical Generator is a Microwave Radical Generator (MRG).

Alternatively, a PECVD process can be used wherein both the silicon precursor and the nitrogen precursor are activated by plasma. The plasma can be located in the reaction chamber or it can be remote.

Another method for depositing the Si₃N₄-like layer can be a thermally activated CVD process, wherein the precursors consist of at least one silane, preferably SiH₄, and NH₃.

For any of the processes carried out, the Si₃N₄-like layer is preferably deposited at a temperature comprised between (about) 400°C and (about) 800°C, more preferably at a temperature comprised between (about) 500°C and (about) 700°C, and in particular at a temperature of (about) 600°C.

As illustrated by figure 1, deposition of only 10 seconds of Si₃N₄-like layer by a RACVD process (corresponding to about 0,25 nm apparent thickness by XPS measurement) results in a significant reduction of HfO₂ growth inhibition.

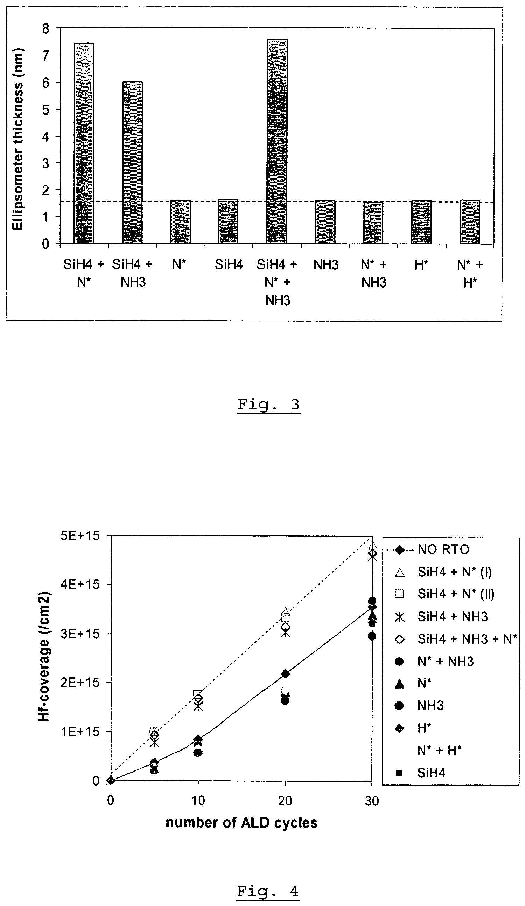

And depositing a larger amount of Si₃N₄-like (thickness of about 4 nm) result in complete elimination of the HfO₂ growth inhibition, as illustrated by figure 4.

Indeed, Figure 4 shows that when NO-RTO grown SiON layers (RTO in NO gas at 1000°C) are treated first with a SiH₄/N* based Radical Assisted CVD process at 600°C, growth inhibition of HfO₂ is strongly reduced or even completely eliminated.

In fact, the mere observation of the growth curves of figure 4 (with the coverage of the deposited layer as a function of the number of ALD reaction cycles) gives a first indication of the effect of the substrate.

Linear growth curves (constant growth rate) are generally associated with good film morphology and fast layer closure.

Growth inhibition (a lower growth rate in the first reaction cycles) indicates the difficult nucleation of the precursors on the substrate and point to island growth, low film quality and late layer closure.

Many other surface treatments of NO-RTO thermally grown SiON tested in the same experiment, such as anneals of the SiON in NH₃, N*, H*, N*/H*, N*/NH₃ or SiH₄, are not successful in eliminating growth inhibition.

Surface treatments with a SiH₄/NH₃ CVD process and a SiH₄/N* or SiH₄/N*/NH₃ RACVD process are all able to eliminate growth inhibition on the chemically very stable thermally grown SiON surface.

In view of the results obtained by a method of the invention, it can be inferred that the deposition of the first few Angstroms of HfO₂ start uniformly everywhere on the surface so that immediately a nice closed monolayer of atoms is formed in the first stages of the deposition, and the film growth continues in a uniform way.

Another object of the present invention relates to a high-k gate stack obtainable by a method of the invention.

A high-k gate stack of the invention can be a stack of layers comprising a growth inhibiting surface, in particular a thermal SiO₂ or a thermal SiON surface, upon which a Si₃N₄-like layer is deposited, upon which a high-k metal oxide (closed) film is deposited. Said high-k metal oxide closed film has a thickness of less than 8 nm, preferably less than (about) 7 nm, more preferably less than (about) 5 nm, less than (about) 4 nm or less than (about) 3 nm, and even more preferably of less than (about) 2 nm.

A high-k gate stack of the invention can also be a stack of layers comprising a growth inhibiting high-k dielectric surface, upon which a Si₃N₄-like layer is deposited, upon which a metal and/or metal nitride (closed) film is deposited as gate electrode. In this case, the high-k gate layer is growth inhibiting and the nitride-like layer is enhancing the growth of the metal or metal nitride gate electrode.

The high-k gate stack obtainable by a method according to the invention suffers less from gate leakage and has a higher capacity, resulting in better semiconductor device perfomance and reliability compared to a high-k gate stack with the same EOT (equivalent oxide thickness) without the Si₃N₄-like layer.

The invention is described in further details in the following examples, which are intended for illustration purposes only, and should not be construed as limiting the scope of the invention in any way.

### EXAMPLES

### EXAMPLE 1.

In a first step, the silicon (Si) substrate is cleaned by hydrofluoric acid (HF) dip.

Upon the silicon substrate, a thermal SiON layer is grown By Rapid Thermal Oxidation in Nitric Oxide (NO) atmosphere at 1000°C (NO-RTO).

Si₃N₄-like layers are then deposited at 600°C by means of Radical Assisted Chemical Vapor Deposition (RACVD) from SiH₄ and Nitrogen radicals and optionally NH₃ precursors, or by means of a thermally activated CVD process, using SiH₄ together with NH₃ precursors.

In order to have comparable results, and since the deposition rate of the CVD process is different from the deposition rate of the RACVD process used in the exemplary processes of table 1, the deposition time is chosen such that the thickness of the Si₃N₄ layer is between about 4 nm and about 5 nm.

Other treatments at 600°C of the NO-RTO SiON layer are also considered.

All process parameters are described in table 1.

All thermal treatments are performed in a nitride CVD reactor, integrated on a Polygon^{®} 8200 platform.

Radicals are generated with a Microwave Radical Generator (MRG).

Upon the different surfaces, with or without the treatments that are summarized in table 1, HfO₂ is deposited in an ASM ALCVD™ Pulsar^{®} 2000 reactor, also integrated on the Polygon^{®} platform.

All HfO₂ depositions are performed at 300°C with HfCl₄ and H₂O precursors.

The pressure in the reactor is 1 Torr (i.e. 0,001333224 bar).

The cycle numbers range between 1 and 100.

Uniform film thickness and low sensitivity towards pulse and purge times indicated that surface saturation is obtained and ALD conditions prevail.

See Table 1.

The HfO₂ growth characteristics for the NO-RTO SiON substrate and NO-RTO SiON/Si₃N₄-like substrates are shown in figure 1.

For NO-RTO SiON substrates, growth inhibition occurs in the first 30 ALD reaction cycles. Such growth inhibition effects of HfO₂ are typical for NO-RTO substrates. They are also observed for O₂-RTO substrates (figure 1). They typically point to island growth.

Depositing a RACVD Si₃N₄-like layer on the NO-RTO SiON substrate improves the HfO₂ nucleation, as shown in figure 1 by a growth curve that shows no little or no sign of growth inhibition anymore.

It is also clear from figure 1 that the HfO₂ growth enhancement depends on the Si₃N₄-like layer deposition time, and thus on the thickness of the Si₃N₄-like layer.

120 seconds Si₃N₄-like deposition results in a linear HfO₂ growth curve, being similar to the one observed for ALD of HfO₂ on a 1 nm Si chemical oxide. A chemical oxide comprises many -OH groups, which are easy sites for nucleation and, consequently, such an oxide is not inflicted with growth inhibition. Unfortunately, such a chemical oxide is electrically of poor quality so that it can not be used in a semiconductor device structure.

Such linear growth curves are associated with two-dimensional growth behavior and good HfO₂ film quality.

The XPS Si₃N₄-like deposition rate at 600°C is 2,1 nm/minute. Thus, 120 seconds of Si₃N₄-like deposition corresponds to a Si₃N₄-like layer thickness of 4.3 nm and results in optimal HfO₂ growth properties.

For 10 seconds of Si₃N₄-like deposition, a significant enhancement in HfO₂ growth rate is observed in the first cycles, although to a smaller extent than for 120 s.

The fact that a 10 seconds Si₃N₄-like layer deposition already results in an improvement of the HfO₂ growth behavior is very interesting for gate stack applications.

For gate stack applications targeting a minimal EOT (Equivalent Oxide Thickness), the Si₃N₄-like layer thickness should be minimal. 10 seconds Si₃N₄-like layer deposition gives a thickness of about 0,25 nm according to XPS (figure 2), corresponding to only about 0,12 nm EOT. Thus, a HfO₂ growth improvement can already be achieved with a minor EOT contribution.

Having regard to the treatments of the NO-RTO surfaces with respectively N*, SiH₄, NH₃, N* + NH₃, H*, and N* + H*, no Si₃N₄-like deposition is observed as illustrated by figure 3.

Ellipsometer results (figure 3) indicate that only three of the considered processes (treatments) result in the actual deposition of a Si₃N₄-like layer: the combination of SiH₄ and N* (by the RACVD process), the combination of SiH4, N* and NH₃ (by the RACVD process), and the combination of SiH₄ and NH₃ (by the (thermal) CVD process).

In those cases, the ellipsometer thickness measured is about 4 nm to about 5 nm thicker than that of the NO-RTO starting layer (having a thickness of about 1,7 nm).

The HfO₂ growth curves on the different substrates are shown in figure 4.

A growth improvement is observed only when a Si₃N₄-like layer is deposited on the NO-RTO substrate.

The layers obtained by RACVD process using SiH₄, N* and optionally NH₃ precursors and by CVD process using SiH₄ and NH₃ precursors, induce the growth improvement.

Other treatments that do not deposit a Si₃N₄-like layer do not result in an improvement in the HfO₂ growth behaviour.

These data suggest that these treatments in SiH₄/N* or SiH₄/NH₃ or SiH₄/N*/NH₃ leave behind a surface that is favorable for HfO₂ growth initiation.

None of the other treatments were able to achieve this on thermal oxide.

The invented treatments, in contrary to the other treatments, do deposit some silicon-nitride-like material on the thermal oxide and apparently leave behind chemical groups (possibly -NH) that are favorable for reaction with the HfCl₄/H₂O precursors of the HfO₂ deposition process.

Moreover, the silicon-nitride-like material that is deposited on the difficult surface is fully compatible with application of the films as gate dielectric.

In conclusion, the growth of HfO₂ on Si₃N₄-like substrates, the latter deposited on thermal SiON (NO-RTO) substrates, is substantially improved.

Both thermal and Radical Assisted CVD Si₃N₄-like layers, deposited at 600°C, are good starting substrates for HfO₂ ALD.

### EXAMPLE 2.

Tungsten nitride carbide (WNC) layers (which can also be referred as tungsten, nitrogen, and carbon containing layers) are deposited by ALD at 300°C on different substrates, namely hydrogen-terminated silicon (H-Si), silicon carbide (SiC), silicon nitride (Si₃N₄), silicon oxide (SiO₂) including oxidized (chemical), thermally grown (thermal) and Plasma Enhanced Chemical Vapor Deposited (PECVD) silicon oxide, and Electrochemical Plated (ECP) copper (Cu).

More particularly, ALD WNC deposition is performed on thermal, chemical and PECVD SiO₂, PECVD SiC, PECVD Si₃N₄, H-Si and Cu.

The ALD WNC deposition is carried out in an ASM Pulsar^{®}2000 reactor. The ALD process cycle comprises a repetitive ABC-type pulse sequence of surface reactions, where individual A, B, and C stand for the precursors triethylborane ((C₂H₅)₃B,), tungsten hexafluoride (WF₆), and ammonia (NH₃), respectively.

WF₆ and NH₃ gases are mixed with nitrogen gas and introduced in the deposition chamber. Liquid (C₂H₅)₃B is evaporated and introduced in the chamber by flowing N₂ gas at 320 hPa over the liquid at 18°C.

The (C₂H₅)₃B, WF₆ and NH₃ precursors are pulsed for 0.7, 0.1, and 1 s respectively. Excess precursor is removed by flowing N₂ gas for 2 s after each precursor pulse.

The temperature during deposition is about 300 °C, and the maximum pressure is about 2 hPa.

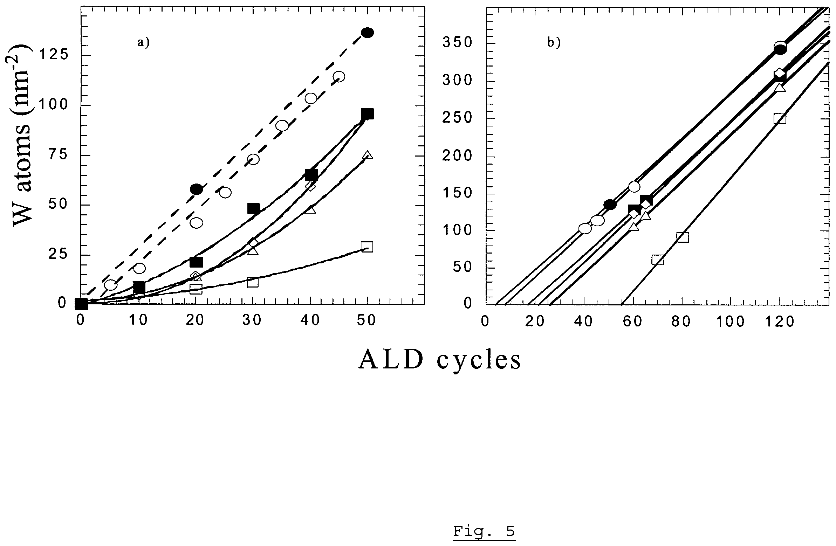

Figure 5 shows W (tungsten) yield as a function of number of ALD cycles for WNC layers grown on thermally grown SiO₂ (open square), PECVD SiO₂ (open diamond), SiC (open triangle), chemical SiO₂ (solid square), Si₃N₄ (open circle) and H-Si (solid circle) substrates in the inhibited growth regime (a) and in the linear (non-inhibited) growth regime (b), all measured by X-Ray Fluorescence (XRF).

ALD WNC layer growth appears to be strongly substrate dependent. While on a Si₃N₄ substrate 10 W atoms per nm² are obtained after deposition of only 5 ALD WNC cycles, on thermal SiO₂ 30 ALD WNC cycles are required to reach the same layer coverage.

The length (in terms of number of ALD cycles) of the inhibited growth regime increases as follows: H-Si < Si₃N₄ < chemical SiO₂ < PECVD SiO₂ < SiC < Cu < thermal SiO₂.

The WNC growth curves on SiC, Cu and the different types of SiO₂ fit to a second order parabolic curve, which is attributed to substrate-inhibited growth due to a lack of reactive sites and is characterized by island growth.

A very short or even no inhibited growth regime characterizes the WNC growth on Si₃N₄. This is due to enhanced binding of WNC to nitrogen-containing groups and compatibility between Si₃N₄ and the W-N material at the interface.

Similarly to HfO₂, a Si₃N₄ layer thickness of about 0,25 nm was already sufficient for generating a significant enhancement of the WNC layer growth.

**Table 1**

| Process | Reactants | **N₂ slm** | **SiH₄ sccm** | **NH₃ (slm)** | **H₂ slm** | **MRG gas** | **p Torr** | **T °C** | **DepRate nm/min** | **SiH₄pp Torr** | **NH₃pp Torr** |
|---|---|---|---|---|---|---|---|---|---|---|---|
| RACVD | SiH4 + N* | 16 | 50 | 0 | 0 | N2 | 2,5 | 600 | 2,90 | 0,01 | 0,00 |
| CVD | SiH4 + NH3 | 5 | 40 | 2 | 0 | - | 55 | 600 | 1,20 | 0,31 | 15,71 |
| RAN | N* | 16 | 0 | 0 | 0 | N2 | 2,5 | 600 | 0,00 | 0,00 | 0,00 |
| CVD | SiH4 | 0 | 50 | 0 | 0 | - | 2,5 | 600 | 0,00 | 2,50 | 0,00 |
| RACVD | SiH4 + N* + NH3 | 21 | 50 | 0,2 | 0 | N2 | 2,5 | 600 | 10,21 | 0,01 | 0,02 |
| RTN | NH3 | 5 | 0 | 2 | 0 | - | 55 | 600 | 0,00 | 0,00 | 15,71 |
| RAN/RTN | N* + NH3 | 21 | 0 | 0,2 | 0 | N2 | 2,5 | 600 | 0,00 | 0,00 | 0,02 |
| RAA | H* | 0 | 0 | 0 | 16 | H2 | 2,5 | 600 | 0,00 | 0,00 | 0,00 |
| RAN/RAA | N* + H* | 11 | 0 | 0 | 5 | N2 + H2 | 2,5 | 600 | 0,00 | 0,00 | 0,00 |

The terms used in table 1 are:
- RACVD: Radical Assisted Chemical Vapor Deposition
- CVD: Chemical Vapor Deposition
- RAN: Radical Assisted Nitridation
- RTN: Raid Thermal Nitridation
- RAA: Radical Assisted Annealing

## Claims

1. Method for reducing growth inhibition of metal oxide, metal nitride and/or metal carbide layer selected from the group consisting of titanium oxide, tantalum oxide, aluminium oxide, zirconium oxide, lanthanum oxide, hafnium oxide, hafnium scandium oxide, hafnium silicon oxide, tantalum nitride, titanium nitride, tungsten nitride, niobium nitride, molybdenum nitride, hafnium nitride, tantalum carbide, titanium carbide, tungsten carbide, niobium carbide, molybdenum carbide, hafnium carbide and any combination of two, three, four or more thereof, said method comprising the steps of depositing said metal oxide, metal nitride and/or metal carbide layer upon a SiₓN_{y} layer having a thickness comprised between 0,25 nm and 4nm, wherein x and y are real numbers, wherein x is comprised between 3 and 10, wherein y is comprised between 0,1 and 4, wherein x and y may be equal or different.

2. A method according to claim 1, wherein said SiₓN_{y} layer is deposited upon a metal growth inhibiting surface, before the step of depositing said metal oxide, metal nitride, and/or metal carbide layer.

3. A method according to claim 2, wherein said metal growth inhibiting surface is selected from the group consisting of silicon oxide and silicon oxynitride.

4. A method according to any of claims 2 to 3, wherein said SiₓN_{y} layer is deposited by a Chemical Vapor Deposition process.

5. A method according to claim 4, wherein said CVD process uses at least one silane and ammonia.

6. A method according to claim 3, wherein said SiₓN_{y} layer is deposited by a Radical Assisted Chemical Vapor Deposition process (RACVD), a Plasma Enhanced Chemical Vapor Deposition (PECVD) process, or a Remote Plasma Enhanced Chemical Vapor Deposition process (RPECVD).

7. A method according to claim 6, wherein said RACVD, RPECVD, or PECVD process uses at least one silane and nitrogen radicals and optionally ammonia.

8. A method according to claim 5 or 7, wherein said at least one silane is selected from the group consisting of monosilane, disilane, trisilane, monochlorosilane, dichlorosilane, trichlorosilane, and tetrachlorosilane.

9. A method according to any of claims 1 to 8, wherein said metal oxide, metal nitride and/or metal carbide is/are deposited by a CVD process, a MOCVD process or an ALD process.

10. Use of a method according to any of claims 2 to 9 for treating said metal growth inhibiting surface for the subsequent deposition of a metal oxide, metal nitride, and/or metal carbide layer.

11. A method for manufacturing a high-k gate stack comprising a method according to any of claims 1 to 9.

12. A method for manufacturing integrated circuits comprising a method according to any of claims 1 to 11.

## Patentansprüche

1. Verfahren zur Reduzierung der Wachstumshemmung einer Metalloxid-, Metallnitrid- und/oder Metallkarbidschicht, die ausgewählt ist aus der Gruppe bestehend aus Titanoxid, Tantaloxid, Aluminiumoxid, Zirkonoxid, Lanthanoxid, Hafniumoxid, Hafniumscandiumoxid, Hafniumsilikonoxid, Tantalnitrid, Titannitrid, Wolframnitrid, Niobnitrid, Molybdännitrid, Hafniumnitrid, Tantalkarbid, Titankarbid, Wolframkarbid, Niobkarbid, Molybdänkarbid, Hafniumkarbid und einer beliebigen Kombination aus zwei, drei, vier oder mehreren dieser, wobei das Verfahren die Schritte der Abscheidung der Metalloxid-, Metallnitrid- und/oder Metallkarbidschicht auf einer SiₓN_{y}-Schicht mit einer Dicke, die zwischen 0,25 nm und 4 nm beträgt, umfasst, wobei x und y reelle Zahlen sind, wobei x zwischen 3 und 10 beträgt, wobei y zwischen 0,1 und 4 beträgt, wobei x und y gleich oder verschieden sein können.

2. Verfahren nach Anspruch 1, wobei die SiₓN_{y}-Schicht vor dem Schritt der Abscheidung der Metalloxid-, Metallnitrid-, und/oder Metallkarbidschicht auf einer Metallwachstumshemmungsfläche abgeschieden wird.

3. Verfahren nach Anspruch 2, wobei die Metallwachstumshemmungsfläche ausgewählt ist aus der Gruppe bestehend aus Silikonoxid und Silikonoxinitrid.

4. Verfahren nach einem der Ansprüche 2 bis 3, wobei die SiₓN_{y}-Schicht anhand eines chemischen Gasphasenabscheidungsverfahrens abgeschieden wird.

5. Verfahren nach Anspruch 4, wobei das CVD-Verfahren wenigstens ein Silan und Ammoniak einsetzt.

6. Verfahren nach Anspruch 3, wobei die SiₓN_{y}-Schicht anhand eines radikalaktivierten chemischen Gasphasenabscheidungsverfahrens (RACVD), eines plasmaaktivierten chemischen Gasphasenabscheidungsverfahrens (PECVD), oder eines fernplasmaaktivierten Gasphasenabscheidungsverfahrens (RPECVD) abgeschieden wird.

7. Verfahren nach Anspruch 6, wobei das RACVD-, RPECVD, oder PECVD-Verfahren wenigstens ein Silan- und Stickstoffradikal und optionales Ammoniak einsetzt.

8. Verfahren nach Anspruch 5 oder 7, wobei das wenigstens ein Silan ausgewählt ist aus der Gruppe bestehend aus Monosilan, Disilan, Trisilan, Monochlorsilan, Dichlorsilan, Trichlorsilan, und Tetrachlorsilan.

9. Verfahren nach einem der Ansprüche 1 bis 8, wobei das Metalloxid, Metallnitrid und/oder Metallkarbid anhand eines CVD-Verfahrens, eines MOCVD-Verfahrens oder eines ALD-Verfahrens abgeschieden wird/werden.

10. Verwendung eines Verfahrens nach einem der Ansprüche 2 bis 9 zur Behandlung der Metallwachstumshemmungsfläche zur anschließenden Abscheidung auf einer Metalloxid-, Metallnitrid-, und/oder Metallkarbidschicht.

11. Verfahren zur Herstellung eines Gate-Stapels mit hoher Dielektrizitätskonstante k, umfassend ein Verfahren nach einem der Ansprüche 1 bis 9.

12. Verfahren zur Herstellung integrierter Halbleiterschaltungen, umfassend ein Verfahren nach einem der Ansprüche 1 bis 11.

## Revendications

1. Procédé de réduction de l'inhibition de croissance d'une couche d'oxyde de métal, de nitrure de métal et/ou de carbure de métal choisie dans le groupe constitué par l'oxyde de titane, l'oxyde de tantale, l'oxyde d'aluminium, l'oxyde de zirconium, l'oxyde de lanthane, l'oxyde d'hafnium, l'oxyde d'hafnium-scandium, l'oxyde d'hafnium-silicium, le nitrure de tantale, le nitrure de titane, le nitrure de tungstène, le nitrure de niobium, le nitrure de molybdène, le nitrure d'hafnium, le carbure de tantale, le carbure de titane, le carbure de tungstène, le carbure de niobium, le carbure de molybdène, le carbure d'hafnium et n'importe quelle combinaison de deux, trois, quatre ou plus de ceux-ci, ledit procédé comprenant les étapes de dépôt de ladite couche d'oxyde de métal, de nitrure de métal et/ou de carbure de métal sur une couche de SiₓN_{y} ayant une épaisseur comprise entre 0,25 nm et 4 nm, où x et y sont des nombres réels, où x est compris entre 3 et 10, où y est compris entre 0, 1 et 4, où x et y peuvent être identiques ou différents.

2. Procédé selon la revendication 1, dans lequel ladite couche de SiₓN_{y} est déposée sur une surface inhibant la croissance de métal, avant l'étape de dépôt de ladite couche d'oxyde de métal, de nitrure de métal et/ou de carbure de métal.

3. Procédé selon la revendication 2, dans lequel ladite surface inhibant la croissance de métal est choisie dans le groupe constitué par l'oxyde de silicium et l'oxynitrure de silicium.

4. Procédé selon l'une quelconque des revendications 2 à 3, dans lequel ladite couche de SiₓN_{y} est déposée par un procédé de dépôt chimique en phase vapeur (CVD).

5. Procédé selon la revendication 4, dans lequel ledit procédé CVD utilise au moins un silane et de l'ammoniac.

6. Procédé selon la revendication 3, dans lequel ladite couche de SiₓN_{y} est déposée par un procédé de dépôt chimique en phase vapeur assisté par un radical (RACVD), un procédé de dépôt chimique en phase vapeur amélioré par plasma (PECVD) ou un procédé de dépôt chimique en phase vapeur amélioré par plasma à distance (RPECVD).

7. Procédé selon la revendication 6, dans lequel ledit procédé RACVD, RPECVD ou PECVD utilise au moins un silane et des radicaux azotés et éventuellement de l'ammoniac.

8. Procédé selon la revendication 5 ou 7, dans lequel ledit au moins un silane est choisi dans le groupe constitué par le monosilane, le disilane, le trisilane, le monochlorosilane, le dichlorosilane, le trichlorosilane et le tétrachlorosilane.

9. Procédé selon l'une quelconque des revendications 1 à 8, dans lequel ledit oxyde de métal, ledit nitrure de métal et/ou ledit carbure de métal est/sont déposé(s) par un procédé CVD, un procédé MOCVD ou un procédé ALD.

10. Utilisation d'un procédé selon l'une quelconque des revendications 2 à 9, pour le traitement de ladite surface inhibant la croissance de métal pour le dépôt ultérieur d'une couche d'oxyde de métal, de nitrure de métal et/ou de carbure de métal.

11. Procédé de fabrication d'un empilement de grilles à k élevée comprenant un procédé selon l'une quelconque des revendications 1 à 9.

12. Procédé de fabrication de circuits intégrés comprenant un procédé selon l'une quelconque des revendications 1 à 11.
